(19) Europäisches Patentamt

European Patent Office

Office européen des brevets

(11) **EP 0 821 493 B1**

(12) **FASCICULE DE BREVET EUROPEEN**

(45) Date de publication et mention
de la délivrance du brevet:
**02.05.2003 Bulletin 2003/18**

(51) Int Cl.⁷: **H03M 13/29**

(21) Numéro de dépôt: **97410077.8**

(22) Date de dépôt: **21.07.1997**

(54) **Système de correction d'erreurs dans des trames de données ayant des codes de parité horizontaux et verticaux**

Fehlerkorrekturssystem in Datenrastern mit horizontalen und vertikalen Paritätskoden

Error correction system in data frames comprising horizontal and vertical parity codes

(84) Etats contractants désignés:
**DE FR GB IT**

(30) Priorité: **23.07.1996 FR 9609488**

(43) Date de publication de la demande:
**28.01.1998 Bulletin 1998/05**

(73) Titulaire: **STMicroelectronics S.A.**
**92120 Montrouge (FR)**

(72) Inventeur: **Meyer, Jacques**
**38700 Corenc (FR)**

(74) Mandataire: **de Beaumont, Michel**
**1bis, rue Champollion**
**38000 Grenoble (FR)**

(56) Documents cités:
**EP-A- 0 114 938**         **EP-A- 0 690 584**
**FR-A- 2 481 027**         **US-A- 5 422 895**

• **PATENT ABSTRACTS OF JAPAN vol. 013, no. 246 (E-769), 8 juin 1989 & JP 01 047132 A (SONY CORP), 21 février 1989,**
• **PATENT ABSTRACTS OF JAPAN vol. 013, no. 246 (E-769), 8 juin 1989 & JP 01 047131 A (SONY CORP), 21 février 1989,**

# EP 0 821 493 B1

## Description

La présente invention concerne un système de correction d'erreurs dans des trames de données comportant des données de parité horizontale et verticale permettant de corriger les erreurs dans la trame par rangées et colonnes. Les rangées et colonnes de données de la trame constituent alors ce que l'on appelle des codes-produit.

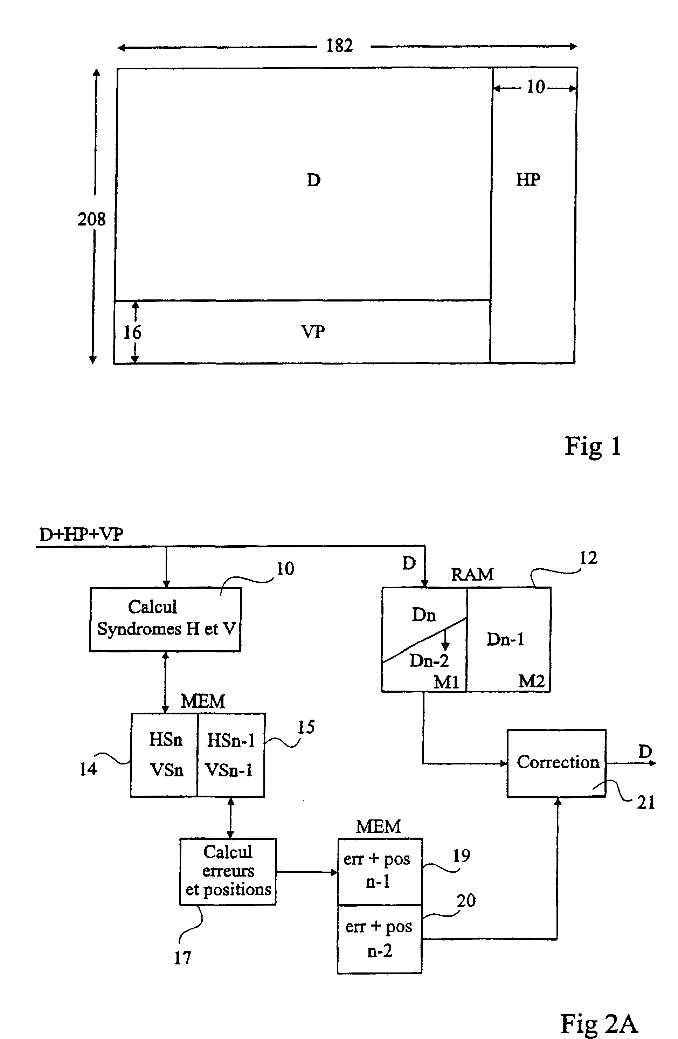

La figure 1 illustre un exemple de trame comportant des rangées de 182 octets et des colonnes de 208 octets. Dix octets dans chaque rangée constituent des données de parité horizontale HP et seize octets dans chaque colonne constituent des données de parité verticale VP. La trame restante de 172x192 octets comporte les données utiles D.

Chaque rangée ou chaque colonne, avec les données de parité correspondantes, constitue, par exemple, un code Reed-Solomon. Avec un code Reed-Solomon à 2k données de parité, on sait trouver, par des méthodes bien connues de la technique, 2k informations d'erreur, le plus souvent k valeurs d'erreur et les k positions correspondantes dans le code. Dans le cadre des codes-produit, comme dans la figure 1, chaque code Reed-Solomon peut être utilisé de manière plus souple, c'est-à-dire que l'on sait trouver, avec 2k données de parité, n erreurs à valeurs et positions inconnues, et m erreurs à valeurs connues et positions inconnues, avec $2n + m \leq 2k$.

Pour effectuer une correction d'erreurs dans un code correspondant à une rangée ou à une colonne, on calcule un syndrome à partir de toutes les données du code, y compris les données de parité. C'est à partir de ce syndrome que l'on sait calculer les valeurs et positions des erreurs.

Si le nombre d'erreurs révélées par un syndrome est maximal, il peut être préférable de ne pas effectuer les corrections correspondantes. En effet, il y a alors une probabilité de l'ordre de $10^{-5}$ horizontalement et de l'ordre de $10^{-8}$ verticalement pour que le code à corriger contienne plus du nombre maximal d'erreurs. Une correction serait alors fausse. Pour rendre la probabilité de fausse correction négligeable, on effectue plusieurs passes de correction dans lesquelles on n'exploite que les syndromes qui révèlent un nombre d'erreurs inférieur à un seuil qui est lui-même inférieur ou égal au nombre maximal. A chaque passe, on corrige les données erronées et on met à jour les syndromes orthogonaux affectés par les corrections, c'est-à-dire les syndromes verticaux des colonnes affectées par les corrections d'une rangée, et les syndromes horizontaux des rangées affectées par les corrections d'une colonne. On parvient ainsi à réduire le nombre d'erreurs par rangée ou colonne en dessous du nombre maximal d'erreurs corrigibles par les syndromes.

En attente d'être corrigées, les données de la trame doivent être stockées. Généralement, on stocke deux trames, à savoir une première en cours de réception et une deuxième en cours de correction. Dans l'exemple de la figure 1, la mémoire requise est de 2x37856 octets. Une mémoire de trame d'une telle capacité n'est pas intégrable à coût raisonnable avec le circuit de correction d'erreurs, et doit donc être externe. Par ailleurs, si on ne prend pas de précautions particulières, on risque de devoir accéder à la mémoire de trame de nombreuses fois au cours du traitement d'une trame, ce qui requiert une mémoire particulièrement rapide et donc coûteuse.

Il est également à noter que le document FR8107715 décrit un circuit de décodage de code produit dans lequel les données reçues et les syndromes horizontaux sont stockés dans des mémoires séparées.

Un objet de la présente invention est de prévoir un système de correction d'erreurs dans des trames de codes-produit, dont la mémoire de trame puisse être lente, c'est-à-dire adaptée seulement à la cadence de transmission des données de la trame.

Un autre objet de la présente invention est de prévoir un tel système dans lequel la mémoire de trame puisse être incorporée dans une mémoire existante d'un circuit d'exploitation des trames corrigées.

Ces objets sont atteints selon l'invention grâce à un procédé qui comprend, selon un premier aspect, les étapes consistant à calculer au vol les syndromes horizontaux et verticaux d'une trame courante sur les données de la trame courante en cours de réception dans une mémoire lente, à stocker ces syndromes dans une zone mémoire rapide, et, tandis que les données de la trame suivante sont reçues dans la mémoire lente, à trouver les valeurs et positions des erreurs de la trame courante à partir des syndromes stockés dans la zone mémoire rapide.

Selon un deuxième aspect indépendant du premier, le procédé comprend les étapes consistant, tandis que les données d'une trame courante sont reçues par rangées, à tenter de corriger au vol les rangées de la trame courante à l'aide des données de parité horizontale, à marquer les positions de rangées douteuses, à calculer au vol les syndromes verticaux de la trame courante sur les rangées corrigées et douteuses en cours de stockage dans une mémoire lente, à stocker ces syndromes verticaux dans une zone mémoire rapide, et, tandis que les données de la trame suivante sont reçues, à trouver les valeurs des erreurs de la trame courante à partir des syndromes verticaux stockés dans la zone mémoire rapide, les positions de ces erreurs étant fournies par le marquage des rangées douteuses.

Selon un mode de réalisation de la présente invention, le procédé comprend l'étape consistant à corriger au vol les données extraites de la mémoire lente à l'aide des valeurs et positions trouvées.

Selon un mode de réalisation de la présente invention, la mémoire lente est gérée par un circuit d'exploitation et les valeurs et positions des erreurs de chaque trame sont fournies au circuit d'exploitation parmi les données de la trame suivante, le circuit d'exploitation étant prévu pour stocker chaque trame et la corriger lors de la réception des valeurs et positions des erreurs correspondantes.

Selon un mode de réalisation de la présente invention, chaque trame est stockée sans ses données de parité, les valeurs et positions des erreurs de la trame étant fournies au circuit d'exploitation pendant la réception des données de parité de la trame suivante.

Selon un mode de réalisation de la présente invention, les données de parité verticale sont entrelacées dans les colonnes, le calcul de syndromes comprenant les étapes consistant à initialiser un premier registre auxiliaire à un élément prédéterminé du corps de Galois, élevé à une puissance correspondant à la première donnée de chaque colonne ; à initialiser un deuxième registre auxiliaire audit élément du corps de Galois, élevé à une puissance correspondant à la première donnée de parité verticale de la colonne ; à initialiser à 1 un registre de variable ; à mettre à jour le premier registre auxiliaire par le produit de son contenu et de l'inverse dudit élément du corps de Galois à chaque arrivée d'une nouvelle donnée de la colonne, sauf lors de l'arrivée d'une donnée de parité verticale ; à mettre à jour le deuxième registre auxiliaire par le produit de son contenu et de l'inverse dudit élément du corps de Galois à chaque arrivée d'une nouvelle donnée de parité verticale de la colonne ; à mettre à jour le registre de variable, pour chaque coefficient de syndrome, par le produit de son contenu et du contenu du deuxième ou premier registre auxiliaire, selon que la donnée couramment reçue de la colonne est une donnée de parité verticale ou non ; et à mettre à jour, dans la zone mémoire rapide, chaque coefficient de syndrome vertical par la somme du coefficient de syndrome et du produit du contenu du registre de variable par la donnée couramment reçue.

Selon un mode de réalisation de la présente invention, la trame de données comporte des signatures de vérification d'erreurs dont chacune correspond au reste de la division par un polynôme générateur d'un polynôme dont les coefficients sont les bits d'une série de données de la trame. Le procédé comprend alors les étapes consistant à initialiser un premier registre, pour chaque erreur trouvée, aux coefficients du polynôme générateur et à le mettre à jour par le carré de son contenu ; à initialiser un registre à décalage à la position de l'erreur dans la série et le cadencer en synchronisme avec les mises à jour du premier registre ; et à initialiser un registre de signature à la valeur de l'erreur et le mettre à jour par le produit de son contenu et du contenu du premier registre seulement lorsque le bit de poids le plus faible du registre à décalage est à 1, d'où il résulte que le registre de signature contient l'influence de l'erreur sur la signature lorsque le registre à décalage a été parcouru.

Selon un mode de réalisation de la présente invention, le procédé, dans son premier aspect, comprend l'étape consistant, tandis que les données de la trame suivante sont reçues, à remplacer, dans la zone mémoire rapide, les coefficients de chaque syndrome par les valeurs et positions des erreurs calculées à partir du syndrome.

Selon un mode de réalisation de la présente invention, le procédé, dans son deuxième aspect, comprend les étapes consistant, tandis que les données de la trame suivante sont reçues, à remplacer, dans la zone mémoire rapide, les coefficients de chaque syndrome vertical par les coefficients d'un polynôme de détermination d'erreur calculé à partir des coefficients du syndrome vertical et des positions des rangées douteuses marquées ; à stocker les coefficients d'un polynôme de localisation d'erreur calculé à partir des positions des rangées douteuses marquées ; et à calculer les valeurs des erreurs à partir des polynômes de détermination d'erreur et du polynôme de localisation d'erreur.

Selon un mode de réalisation de la présente invention, le procédé, dans son deuxième aspect, comprend les étapes consistant à calculer les syndromes verticaux de la trame courante en annulant les données de chaque rangée douteuse, et, pendant la réception d'une rangée de données de parité verticale de la trame suivante, à écrire les valeurs d'erreur calculées pour une rangée douteuse dans la mémoire lente à la place de cette rangée douteuse.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, précédemment décrite, illustre un exemple de trame constituée de codes-produit de correction d'erreurs ;
la figure 2A illustre une architecture schématique d'un premier mode de réalisation de système de correction d'erreurs selon la présente invention ;
la figure 2B illustre une variante avantageuse de mode de réalisation de la figure 2A ;
la figure 3 illustre une architecture schématique d'un deuxième mode de réalisation de système de correction d'erreurs selon la présente invention ;
la figure 4 illustre une trame de données dans laquelle les rangées de données de parité verticale sont entrelacées avec les rangées de données utiles ;
la figure 5 représente schématiquement un mode de réalisation de circuit de calcul de syndromes au vol pour des trames du type de la figure 4 ;
la figure 6 représente un mode de réalisation de circuit de calcul de l'influence d'une erreur sur une signature de vérification d'absence d'erreur dans une application du mode de réalisation de la figure 3 ; et
la figure 7 illustre une architecture schématique d'un troisième mode de réalisation de système de correction d'erreurs selon la présente invention.

Un aspect de l'invention est de constater que, pour trouver les erreurs dans une trame de codes-produit, telle que celle de la figure 1, il suffit de calculer les syndromes horizontaux et verticaux une seule fois à partir de toutes les données de la trame. Une fois ces syndromes calculés, on n'a plus besoin des données de la trame pour calculer les valeurs et les positions des erreurs, même si l'on procède en plusieurs passes.

Ainsi, selon cet aspect, on commence par trouver toutes les valeurs et positions des erreurs dans le but de corriger ultérieurement les données utiles de la trame, à partir seulement des syndromes. Les syndromes sont calculés au vol lors de la réception des données de la trame et stockés dans une mémoire dont la capacité est telle qu'elle peut être intégrée. Alors, les opérations de calcul d'erreur s'effectuent à partir des syndromes stockés dans une mémoire intégrée dont la rapidité est particulièrement élevée du fait que les connexions avec la mémoire sont courtes et que l'on travaille à la fréquence maximale de la technologie. Par ailleurs, dans un circuit intégré, on peut augmenter la puissance de calcul en augmentant la taille du bus d'accès à la mémoire interne, ou bien le nombre de mémoires internes, avec moins de contraintes que pour des mémoires externes.

En conséquence, tous les traitements nécessitant un débit d'échange élevé avec une mémoire s'effectuent avec une mémoire intégrée adaptée à ces débits, tandis que la mémoire de trame externe ne voit que le débit relativement lent des données de la trame. Par ailleurs, cette mémoire externe n'a plus besoin de stocker les données de parité.

La figure 2A représente schématiquement une architecture d'un premier mode de réalisation de système de correction d'erreur selon l'invention. Les données d'une trame à traiter, c'est-à-dire les données utiles D, les données de parité horizontale HP et les données de parité verticale VP arrivent en même temps sur un circuit de calcul de syndromes 10 et sur une mémoire de trame externe 12. La mémoire 12 comporte deux zones M1 et M2 dont chacune est destinée à stocker les données utiles D d'une trame.

Le circuit de calcul de syndromes 10 est associé à une première zone mémoire interne 14 dans laquelle sont stockés des syndromes horizontaux HSn et verticaux VSn en cours de calcul. Une deuxième zone mémoire interne 15 stocke les syndromes horizontaux HSn-1 et verticaux VSn-1 calculés pour une trame précédente n-1 par le circuit 10. Un circuit de calcul d'erreur 17 est associé à cette zone mémoire 15 et fournit les valeurs et positions des erreurs de la trame n-1 à une troisième zone mémoire interne 19. Une quatrième zone mémoire interne 20 stocke les valeurs et positions des erreurs précédemment calculées pour une trame n-2 par le circuit 17. Un circuit de correction d'erreur 21 reçoit de la mémoire externe 12 les données utiles D de la trame n-2 à transmettre et reçoit les valeurs et positions des erreurs correspondantes de la zone mémoire 20.

Lors de la réception d'une trame courante n, les données utiles Dn de la trame sont écrites dans l'une des zones de la mémoire externe 12, par exemple la zone M1, tandis que les données Dn-2 précédemment stockées dans cette zone M1, appartenant à l'avant-dernière trame n-2, sont transmises et corrigées par le circuit de correction 21. La zone M2 de la mémoire externe 12 stocke les données utiles Dn-1 de la trame précédente n-1. Les zones M1 et M2 sont utilisées circulairement, c'est-à-dire que la trame suivante n+1 sera stockée dans la zone M2 tandis que l'on transmet et corrige la trame n-1.

A chaque réception d'une donnée (1 octet) de la trame courante n, le circuit de calcul 10 met à jour les syndromes horizontal et vertical correspondants dans la zone mémoire interne 14. Un syndrome comporte autant de coefficients ou octets qu'il y a de données de parité dans le code correspondant. Dans le cas de la figure 1, chaque syndrome horizontal comporte 10 octets et chaque syndrome vertical comporte 16 octets. Ainsi, la mise à jour d'un syndrome horizontal et d'un syndrome vertical implique la lecture de 26 octets dans la zone mémoire 14 et la réécriture de ces 26 octets mis à jour. Ceci coûte 52 accès d'octet pour chaque donnée de la trame, soit près de deux millions d'accès d'octet pour la trame entière. Le calcul des syndromes au vol constitue l'une des tâches qui nécessitent le plus de puissance de calcul dans le système. Cette puissance de calcul pourra être adaptée en augmentant le nombre d'octets traités en parallèle, c'est-à-dire la largeur du bus de la zone mémoire 14 (et 15).

Les zones mémoire 14 et 15 sont utilisées de manière circulaire, c'est-à-dire que, à la réception de la trame n+1, le circuit de calcul de syndromes 10 met à jour les syndromes de la trame n+1 dans la zone mémoire 15 et le circuit de calcul d'erreur 17 utilise les syndromes horizontaux et verticaux HSn et VSn de la zone mémoire 14.

Pour calculer les valeurs et positions des erreurs, le circuit de calcul 17 effectue, par exemple, deux passes afin d'éviter les risques de fausse correction. A la première passe, il n'exploite que les syndromes qui révèlent un nombre d'erreurs inférieur au nombre maximal d'erreurs corrigibles. Dans le cas de la figure 1, il exploite les syndromes horizontaux qui révèlent, par exemple, au plus 4 erreurs, et les syndromes verticaux qui révèlent, par exemple, au plus 7 erreurs. A la deuxième passe, il est très probable que les erreurs restantes puissent être calculées.

Plus spécifiquement, pour chaque syndrome et à chaque passe, le circuit de calcul d'erreur 17 effectue les opérations suivantes. Les octets du syndrome sont lus dans la zone mémoire 15 et stockés dans un registre afin de les traiter de manière classique pour trouver les valeurs et positions des erreurs, comme cela est décrit, par exemple, dans la demande de brevet français 2 721 775. Les valeurs et positions des erreurs trouvées sont temporairement mémorisées au cours du traitement du syndrome.

A la fin du traitement du syndrome, on sait si les erreurs sont corrigibles et on connaît leur nombre. Si le nombre d'erreurs trouvées est inférieur au nombre maximal, les valeurs et positions sont stockées dans la zone 19, on annule dans la zone 15 le syndrome qui vient d'être traité, et on met à jour les syndromes orthogonaux affectés. Dans le cas contraire, le traitement qui vient d'être effectué est ignoré et on passe au syndrome suivant.

Dans le cas d'un codage Reed-Solomon, pour toute erreur $e_{rc}$ trouvée (où r désigne la rangée contenant l'erreur et c la colonne contenant l'erreur), chaque octet $S_v$ d'un syndrome orthogonal vertical (v = 0 à 15 dans le cas de la figure 1) est modifié selon la relation :

$$S_v = S_v + \alpha^{rv} e_{rc}$$

où $\alpha$ est un élément prédéterminé non-nul et non-unitaire du corps de Galois sur lequel sont définis les codes Reed-Solomon utilisés. De façon similaire, chaque octet $S_h$ d'un syndrome orthogonal horizontal (h = 0 à 9 dans le cas de la figure 1), est modifié selon la relation :

$$S_h = S_h + \alpha^{ch} e_{rc}.$$

Une telle mise à jour d'un syndrome orthogonal correspond à une situation où l'on aurait corrigé la donnée erronée à la position (r, c) d'une trame mémorisée et où l'on aurait recalculé le syndrome orthogonal horizontal ou vertical à partir de la rangée r ou de la colonne c. Ainsi, selon l'invention, les syndromes orthogonaux sont mis à jour par des simples opérations de multiplication et d'addition sur chacun des coefficients du syndrome au lieu de devoir recalculer chaque coefficient de syndrome à partir de chacune des données de la colonne ou rangée correspondante.

Ces calculs impliquent un nombre important d'accès aux octets de syndrome dans la zone mémoire 15 pour chaque erreur. Toutefois, comme le nombre d'erreurs est faible par rapport au nombre de données de la trame, la puissance de calcul requise s'avère inférieure à celle du circuit 10 de calcul au vol des syndromes.

Le circuit de correction 21 lit les données de la trame n-2, stockées dans la zone M1 de la mémoire externe 12, afin de les corriger tandis qu'elles sont transmises. Pour chaque donnée reçue par le circuit de correction 21, ce circuit 21 vérifie dans la zone mémoire 20 s'il existe une position d'erreur associée à la donnée. Si c'est le cas, la donnée est corrigée par l'erreur correspondante. Diverses méthodes peuvent être utilisées pour accéder aux valeurs et positions des erreurs stockées dans la zone mémoire 20 dans l'ordre correspondant aux données à transmettre.

Les zones mémoire 19 et 20 sont utilisées de manière circulaire, c'est-à-dire que, à la réception de la trame n+1, le circuit de calcul d'erreur 17 stocke les valeurs et positions des erreurs de la trame n dans la zone mémoire 20 et le circuit 21 corrige la trame n-1 à partir des valeurs et positions des erreurs stockées dans la zone mémoire 19.

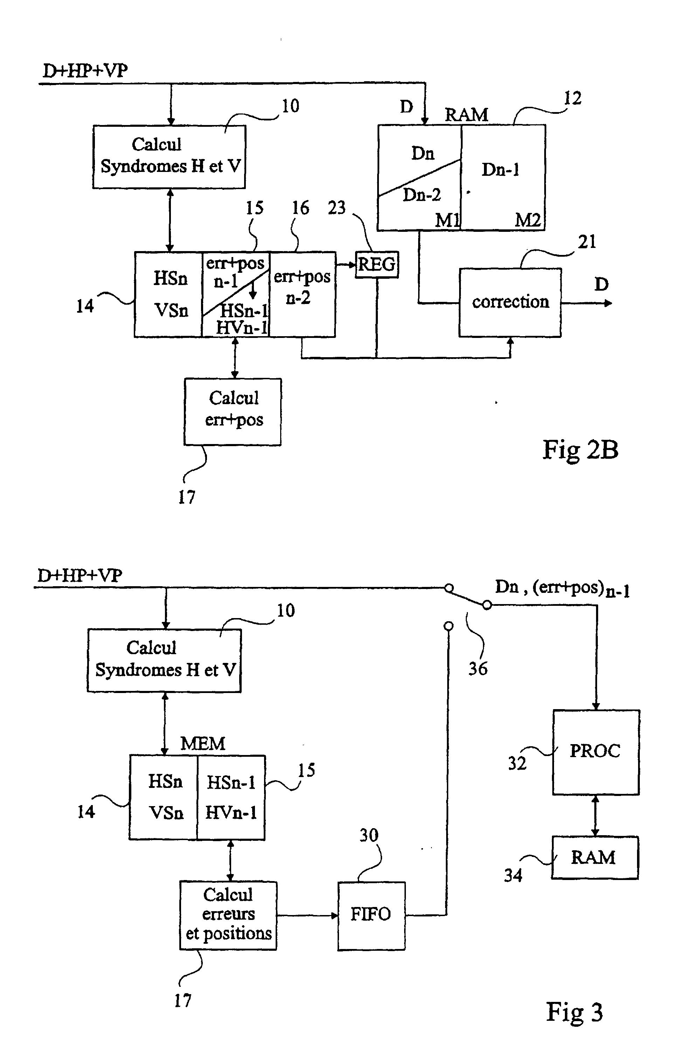

La figure 2B illustre une variante de l'architecture de la figure 2A qui a l'avantage de permettre la fourniture des valeurs et positions des erreurs au circuit de correction 21 dans le bon ordre, tout en nécessitant peu de matériel et de puissance de calcul.

L'architecture de la figure 2B comporte, outre les deux zones de syndrome 14 et 15, une zone de syndrome supplémentaire 16. Les zones mémoire 19 et 20 de la figure 2A sont incorporées dans deux des trois zones de syndrome 14 à 16. Par ailleurs, à chaque syndrome sont associés plusieurs drapeaux, au moins un drapeau "trop d'erreurs" qui indique que le syndrome associé ne permet pas de corriger les erreurs et un drapeau "erreurs corrigées" indiquant que le syndrome associé a permis de corriger les erreurs. De préférence, on prévoit également un drapeau "aucune erreur" indiquant que le syndrome est nul.

A chaque réception d'une donnée de la trame courante n, le circuit de calcul 10 met à jour les syndromes horizontal et vertical correspondants dans la zone mémoire 14. Ces syndromes sont calculés de la manière décrite en relation avec la figure 2A.

La zone mémoire 15, au début de la réception des données de la trame n, contient les syndromes horizontaux et verticaux calculés pour la trame précédente n-1. Au cours de la réception de la trame n, le circuit de calcul d'erreur 17 traite successivement les syndromes contenus dans la zone 15. Plusieurs cas se présentent alors :

- le syndrome est nul. Il n'y a donc aucune erreur. Le drapeau "aucune erreur" est validé.
- Le syndrome indique trop d'erreurs, soit parce que le nombre d'erreurs est supérieur au nombre d'erreurs corrigibles, soit parce que le nombre d'erreurs est égal au nombre maximal d'erreurs corrigibles. Le syndrome est alors laissé inchangé et son drapeau "trop d'erreurs" est validé.
- Le nombre d'erreurs est acceptable. Le circuit de calcul 17 détermine alors les valeurs et positions des erreurs de manière classique et met à jour les syndromes orthogonaux. Les valeurs et positions des erreurs trouvées sont stockées à la place du syndrome et le drapeau "erreurs corrigées" du syndrome est validé. Les valeurs et positions des erreurs sont de préférence stockées consécutivement à la place des coefficients de syndrome.

La zone mémoire 16 stocke les valeurs et positions des erreurs ainsi trouvées pour la trame n-2 qui est en cours de transmission et de correction par le circuit 21.

Le rang de chaque donnée transmise par le circuit 21 fournit directement les adresses des syndromes horizontal et vertical correspondants dans la zone 16, lesquels syndromes ont été remplacés par les valeurs et positions des erreurs trouvées dans la rangée et la colonne de la donnée couramment transmise. Ainsi, pour corriger la donnée transmise, il suffit de parcourir les erreurs stockées à la place des syndromes horizontal et vertical correspondants, jusqu'à ce que la position d'erreur stockée corresponde au rang de la donnée. Dans l'exemple de la figure 1, on parcourt au plus cinq erreurs horizontales et huit erreurs verticales avant de trouver l'erreur correspondant à la donnée transmise. Bien entendu, si on ne trouve pas de position d'erreur correspondante, la donnée ne comporte pas d'erreur.

En pratique, on exploite les drapeaux des syndromes horizontal et vertical correspondant à la donnée transmise de la manière suivante :

- le drapeau "erreurs corrigées" est validé pour chacun des deux syndromes : les erreurs horizontales et verticales sont toutes parcourues.
- Le drapeau "absence d'erreurs" est validé pour au moins un des syndromes : la donnée ne comporte pas d'erreur.
- Le drapeau "trop d'erreurs" est validé pour chacun des deux syndromes : la donnée comporte une erreur incorrigible.
- Le drapeau "trop d'erreurs" est validé pour l'un des syndromes et le drapeau "erreurs corrigées" pour l'autre : la donnée peut comporter une erreur corrigible et on ne parcourt que les erreurs associées au syndrome pour lequel le drapeau "erreurs corrigées" est validé.

Les méthodes de calcul d'erreur classiques permettent de trouver les erreurs dans l'ordre de la transmission des données. Ainsi, en transmettant les données par rangées, on peut se contenter de ne parcourir qu'une seule erreur horizontale pour chaque donnée transmise. C'est-à-dire que l'on sélectionne une seule erreur horizontale pour vérification et on attend l'arrivée de la donnée correspondante avant de sélectionner pour vérification l'erreur horizontale suivante. Pour cela, on prévoit, par exemple, un registre d'erreur 23 dans lequel on commence par stocker la valeur et la position de la première erreur dès la transmission de la première donnée d'une rangée. Pour chaque donnée transmise, on vérifie si elle est associée à l'erreur contenue dans le registre 23. Si c'est le cas, la donnée transmise est corrigée et on remplace le contenu du registre 23 par l'erreur horizontale suivante.

Les zones mémoire 14 à 16 sont utilisées de manière circulaire. C'est-à-dire que, à la réception de la trame n+1, le circuit de calcul de syndromes 10 met à jour les syndromes dans la zone 15, le circuit de calcul d'erreurs 17 utilise la zone 16 pour trouver et stocker les erreurs, et le circuit de correction 21 utilise la zone 14.

Dans la plupart des cas d'utilisation de trames de codes-produit, le circuit qui exploite les trames corrigées possède un élément programmable, tel qu'un microcontrôleur ou un microprocesseur, et une mémoire associée.

La figure 3 représente un mode de réalisation de l'invention permettant d'utiliser la mémoire du circuit d'exploitation pour stocker les données de trame en attente de leur correction. En d'autres termes, la mémoire externe 16 de la figure 2A est incorporée dans la mémoire du circuit d'exploitation. Un tel circuit d'exploitation est, par exemple, un décodeur MPEG ou un micro-ordinateur dont la mémoire, en quantité abondante, dispose de suffisamment de place libre pour pouvoir stocker les trames avant correction d'erreur, ou bien peut être augmentée à faible coût.

Le système de la figure 3 comporte le circuit de calcul de syndromes 10, les zones mémoire intégrées 14 et 15, et le circuit de calcul d'erreur 17 déjà décrits en relation avec la figure 2A. Par contre, le système de la figure 3 ne comporte ni la mémoire externe 12 ni le circuit de correction 21. Les zones mémoire 19 et 20 servant à stocker les valeurs et positions des erreurs sont remplacées par une mémoire tampon 30. Le circuit d'exploitation des trames de données comporte un processeur 32 associé à une mémoire 34.

Lors de la réception d'une trame courante n, les données utiles Dn sont transmises directement vers le processeur 32 par l'intermédiaire d'un commutateur ou multiplexeur 36. Pendant ce temps, le circuit de calcul de syndromes 10 met à jour, comme dans la figure 2A, les syndromes horizontaux et verticaux de la trame n dans la zone mémoire 14, et le circuit de calcul d'erreur 17 trouve les valeurs et positions des erreurs de la trame précédente n-1 à partir des syndromes stockés dans la zone mémoire 15. Les valeurs et positions des erreurs sont stockées temporairement dans la mémoire tampon 30 en attente de les transmettre vers le processeur 32 par l'intermédiaire du commutateur 36.

Le commutateur 36 sélectionne la sortie de la mémoire tampon 30 tandis qu'arrivent les données de parité horizontale HP et verticale VP de la trame courante n. Ainsi, le processeur 32 reçoit les données utiles Dn de la trame courante et, parmi ces données, les valeurs et positions des erreurs de la trame précédente n-1. La somme des intervalles de temps pendant lesquels arrivent les données de parité d'une trame suffit généralement pour transmettre toutes les valeurs et positions des erreurs de la trame précédente.

Le processeur 32 sera programmé pour stocker dans une zone de sa mémoire 34 la trame courante n et la trame précédente n-1 et pour corriger les données de la trame précédente n-1 à l'aide des valeurs et positions des erreurs reçues parmi les données de la trame courante n.

Dans des applications courantes, le processeur 32 peut être celui d'un décodeur MPEG, d'un micro-ordinateur, ou celui qui gère ce qu'on appelle la mémoire tampon "élastique" dans un appareil de lecture de disques vidéo numériques (DVD).

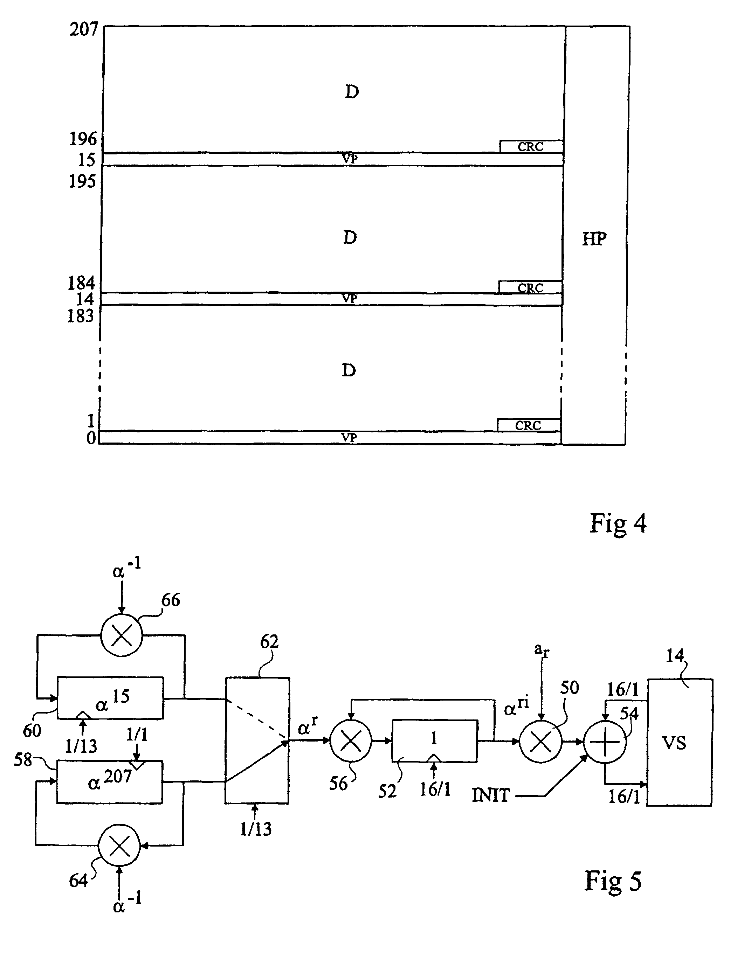

Comme le représente la figure 4, dans certaines applications, les rangées de données de parité verticale VP peuvent être entrelacées avec les rangées de données utiles D. C'est le cas notamment pour les données enregistrées sur les disques vidéo numériques DVD. Ainsi, chaque treizième rangée de données de la trame est une rangée de données de parité verticale. Les rangs des rangées des données de parité verticale VP vont de 0 à 15 et les rangs des rangées de données utiles D vont de 16 à 207. Comme cela est indiqué à la figure 4, la rangée 15 se trouve entre les rangées 195 et 196, la rangée 14 se trouve entre les rangées 183 et 184, etc.

La figure 5 représente schématiquement un circuit permettant de calculer au vol les syndromes verticaux dans le cas de la figure 4. Le i-ème coefficient d'un syndrome s'exprime par :

$$S_i = a_{207} \; \alpha^{207i} + a_{206} \; \alpha^{206i} + ... + a_r \alpha^{ri} + ... + a_0$$

où $a_r$ est la donnée de rang r dans la colonne sur laquelle on calcule le syndrome, et $\alpha$ un élément prédéterminé non-nul et non-unitaire du corps de Galois sur lequel est défini le code de correction d'erreur. Le circuit de la figure 5 est destiné à mettre à jour chaque coefficient de syndrome $S_i$ en le remplaçant par $S_i + a_r \alpha^{ri}$.

Les données $a_r$ de la colonne arrivent successivement, généralement par rangs r décroissants, sur un multiplieur 50 où chaque donnée est multipliée par la puissance adéquate de $\alpha$ stockée dans un registre 52. Un additionneur 54 reçoit la sortie du multiplieur 50 et chacun des coefficients de syndrome à modifier de la zone mémoire 14. Le coefficient de syndrome mis à jour est fourni par l'additionneur 54 à la zone mémoire 14 où il écrase le coefficient précédent. Un multiplieur 56 met à jour le contenu du registre 52 par le produit de son contenu et du contenu de l'un ou l'autre de deux registres 58 et 60 sélectionné par un multiplexeur 62. Un multiplieur 64 met à jour le contenu du registre 58 par le produit de son contenu et de la constante $\alpha^{-1}$. Un multiplieur 66 effectue cette même opération sur le registre 60.

A l'arrivée de la première donnée $a_{207}$ d'une colonne, le registre 52 est initialisé à 1, le registre 58 à $\alpha^{207}$ et le registre 60 à $\alpha^{15}$. Le multiplexeur 62 sélectionne le registre 58, c'est-à-dire la valeur $\alpha^{207}$.

A chaque réception d'une nouvelle donnée de la colonne, le registre 58 est validé, ce qui est illustré par un signal 1/1. En conséquence, à la réception de la donnée $a_r$ de la colonne, où r décroît, le registre 58 contient la valeur $\alpha^r$. A chaque treizième donnée de la colonne, le multiplexeur 62 est commuté, le temps de réception de cette treizième donnée, vers le registre 60 qui est en même temps validé. La commutation du multiplexeur 62 et la validation du registre 60 sont illustrées par un signal 1/13. De cette manière, le multiplexeur 62 fournit toujours le terme $\alpha^r$ adéquat, correspondant à la donnée courante de la colonne, en tenant compte de l'entrelacement.

Pour chaque donnée $a_r$ de la colonne, le registre 52 est initialisé à 1 puis validé 16 fois, c'est-à-dire une fois pour chaque coefficient de syndrome, ce qui est illustré par un signal 16/1. Ainsi, le registre 52 contient successivement les termes $\alpha^{ri}$, pour i variant de 0 à 15, nécessaires pour mettre à jour les 16 syndromes $S_i$. Les 16 termes $\alpha^{ri}$ sont multipliés par la donnée $a_r$ avant d'être présentés à l'additionneur 54 qui reçoit par ailleurs les 16 coefficients de syndrome stockés dans la zone mémoire 14 pour les mettre à jour.

Au début d'une colonne, l'additionneur 54 est initialisé par un signal INIT de manière à ajouter la valeur 0 à la sortie du multiplieur 50 et non les 16 coefficients de syndrome calculés pour la colonne précédente.

Le même circuit que celui de la figure 5, sans les éléments 60, 62 et 66 qui sont prévus pour tenir compte de l'entrelacement, peut être utilisé pour calculer les syndromes horizontaux, le registre 58 étant alors initialisé à $\alpha^{181}$. On préférera toutefois un circuit plus simple du type compteur polynomial qui met à jour chaque coefficient de syndrome $S_i$ par la valeur $\alpha^i S_i + a_c$, où c est le rang (décroissant) de la donnée reçue dans la rangée sur laquelle on calcule le syndrome.

Un circuit du type de la figure 5, sans les éléments 60, 62 et 66, peut également être utilisé pour mettre à jour les syndromes en fonction des erreurs trouvées. Les erreurs sont alors fournies au multiplieur 50 à la place des données $\underline{a}$. Pour chaque erreur $e_j$, où j est le rang (décroissant) de l'erreur dans la rangée ou colonne dont on veut mettre à jour le syndrome, le registre 58 est validé d'abord un certain nombre de fois "à vide", c'est-à-dire sans valider le registre 52 ni effectuer d'accès à la zone mémoire 14, pour que le registre 58 atteigne la valeur $\alpha^j$ correspondant à l'erreur. Le nombre de validations à vide est de 207-j pour une colonne et 181-j pour une rangée.

Dans le cas du disque numérique vidéo, comme cela est représenté à la figure 4, chaque tranche de 12 rangées de données utiles se termine par une signature (CRC) de 32 bits qui a été initialement calculée sur l'ensemble des bits de la tranche. Cette signature sert à vérifier si les erreurs de la tranche ont bien été corrigées.

Chaque signature CRC correspond au reste de la division d'un polynôme, dont les coefficients sont les bits de la tranche associée, par un polynôme générateur de degré 32. Dans le cas des disques vidéo numériques, le

polynôme générateur est $x^{32} + x^{31} + x^4 + 1$. Ainsi, normalement, une fois que les données ont été corrigées, on recalcule les signatures pour vérifier si elles correspondent bien aux signatures initiales.

Le calcul de signature pour vérification est réalisé en fournissant les bits consécutifs de la tranche corrigée, par exemple après le circuit de correction 21 de la figure 2A, à un registre à décalage à contre-réaction linéaire ou LFSR ("Linear Feedback Shift Register"). Toutefois, dans le mode de réalisation de la figure 3, les tranches corrigées ne sont pas disponibles dans le système de correction. On dispose seulement des tranches non-corrigées et des valeurs et positions des erreurs.

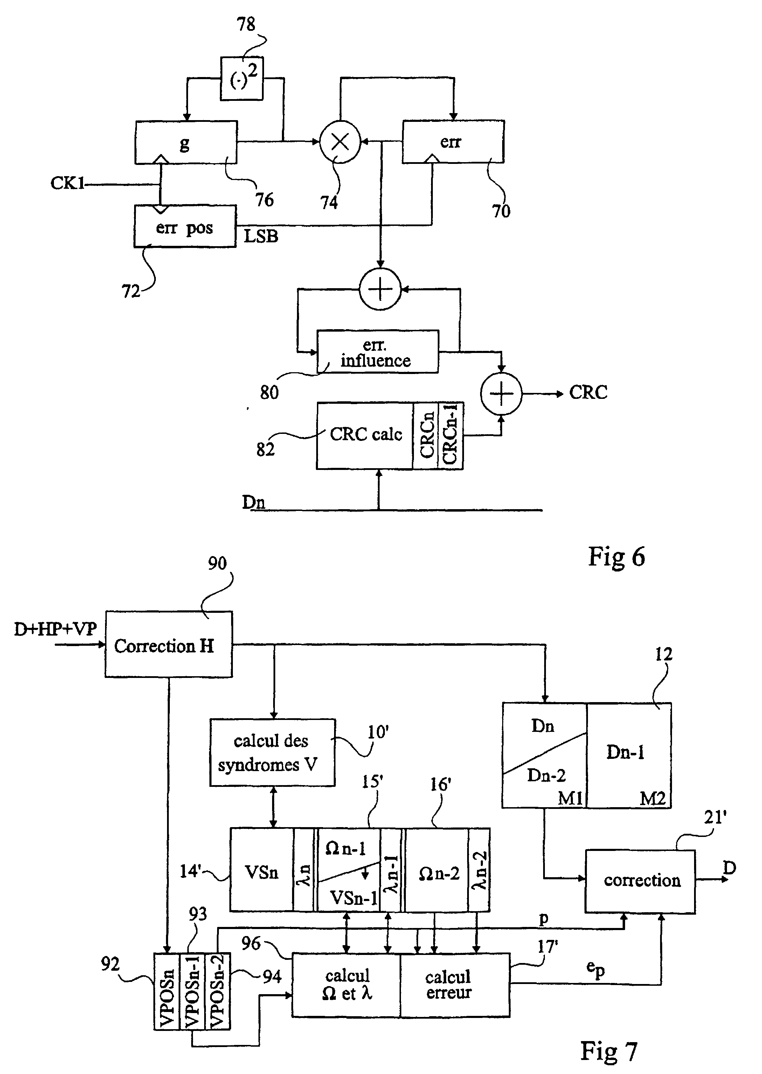

La figure 6 illustre un exemple de circuit permettant de trouver les signatures des tranches corrigées à partir des erreurs et des signatures des tranches non-corrigées.

Le circuit de la figure 6 est basé sur la décomposition en une somme de puissances de deux de la position d'un bit erroné dans la tranche. Si un bit se trouvant à la position x dans la tranche a subi une erreur e, l'influence de cette erreur sur la signature s'exprime par $eg^x$, où g est le polynôme générateur. Le circuit de la figure 6 permet de calculer cette influence particulièrement rapidement et en utilisant peu de surface de silicium.

Un registre 70, de 32 bits, est initialisé avec l'erreur e dont on veut calculer l'influence sur la signature d'une tranche. Les erreurs étant trouvées par octets et les signatures étant calculées sur 32 bits, chaque octet d'erreur de rang x dans la tranche est formaté selon un mot d'erreur e de 32 bits dont l'octet de poids x modulo 4 contient l'octet d'erreur, les autres octets du mot étant nuls. Ce mot d'erreur e est chargé dans le registre 70. Dans un registre à décalage 72, on charge le rang i du mot d'erreur dans la tranche, avec i = x/4. Ainsi, le rang i varie de 0 à 514 (le mot de signature étant exclu de la tranche), ce qui nécessite un registre à décalage 72 de 10 bits. Le bit de poids le plus faible LSB du registre à décalage 72 valide la mise à jour du registre 70. Un multiplieur 74 de nombres de 32 bits reçoit, pour mettre à jour le registre 70, le contenu de ce registre 70 et le contenu d'un registre 76. Le registre 76 contient initialement les coefficients du polynôme générateur g. Un circuit élévateur au carré 78 reçoit le contenu du registre 76 pour le remplacer par son carré. Les registres 76 et 72 sont validés par un même signal d'horloge CK1.

Pour trouver l'influence de l'erreur, le signal d'horloge CK1 est activé 10 fois, afin de décaler la totalité du contenu du registre à décalage 72. Le registre 76 contient alors la puissance 1024-ième du polynôme générateur. Le registre 70 n'aura été validé que pour les bits à 1 du registre à décalage 72 et contient l'erreur multipliée par $g^i$.

Le tableau ci-dessous illustre, dans le cas d'un exemple où i = 145, les contenus successifs des registres 72, 76 et 70 :

| REGISTRE 72 | REGISTRE 76 | REGISTRE 70 |
|---|---|---|
| 00**1**00100**1** | g | e |
| 00**1**00**1**000 | $g^2$ | eg |
| 00**1**00**1**00 | $g^4$ | eg |
| 00**1**00**1**0 | $g^8$ | eg |
| 00**1**00**1** | $g^{16}$ | eg |
| 00**1**00 | $g^{32}$ | $eg \cdot g^{16} = eg^{17}$ |
| 00**1**0 | $g^{64}$ | $eg^{17}$ |
| 00**1** | $g^{128}$ | $eg^{17}$ |
| 00 | $g^{256}$ | $eg^{17}g^{128} = eg^{145}$ |
| 0 | $g^{512}$ | $eg^{145}$ |
|  | $g^{1024}$ | $eg^{145}$ |

Chaque influence d'erreur ainsi obtenue dans le registre 70 est accumulée dans un registre 80 pour chaque tranche de données. Un circuit de calcul de signature classique 82 stocke temporairement la signature CRCn-1 calculée sur les données Dn-1 non-corrigées de la tranche précédente, tandis qu'il calcule la signature CRCn sur les données Dn non-corrigées de la tranche en cours. La signature rectifiée CRC est obtenue en ajoutant la signature CRCn-1 à la signature contenue dans le registre 80. Cette signature rectifiée CRC est celle que l'on compare à la signature d'origine.

Une élévation au carré dans un corps de Galois est une opération particulièrement simple. Ainsi, le circuit d'élévation au carré 78 occupe une faible surface de silicium. Une multiplication sur le corps de Galois de deux nombres de 32 bits est relativement complexe si elle doit être effectuée en un cycle. On préférera utiliser un multiplieur 74 de type série qui effectue la multiplication en 32 cycles, mais dont la structure est particulièrement simple. Alors, l'influence de chaque erreur sur la signature est obtenue en 10x32 = 320 cycles, ce qui représente toutefois une puissance de calcul inférieure à celle du circuit de calcul de syndromes 10, compte tenu du faible nombre d'erreurs.

Le système selon l'invention qui vient d'être décrit permet de corriger des trames du type de la figure 1 comportant un taux d'erreur d'environ 2 % avec deux passes de correction horizontale et verticale. Dans certaines applications, telles que les disques vidéo numériques, le taux d'erreur maximal est notablement plus faible. Il en résulte que le système de correction qui vient d'être décrit serait surdimensionné pour ces applications.

La figure 7 représente un mode de réalisation de système de correction selon l'invention qui permet de corriger des trames du type de la figure 1 comportant un taux d'erreur de 0,8 %. Ce système est similaire à celui de la figure 2B en ce qu'il comprend un circuit de calcul de syndromes 10', une mémoire de trame externe 12, des zones mémoire internes 14' à 16', un circuit de calcul d'erreur 17', et un circuit de correction 21'.

Les données d'une trame courante n à corriger arrivent sur un circuit de correction horizontale 90 qui corrige au vol les rangées de la trame à l'aide des données de parité horizontale HP. Le circuit 90 est un circuit de correction de type classique destiné à corriger des codes "unidimensionnels". Toutefois, comme cela a été expliqué précédemment, le circuit 90 n'effectuera pas de correction si une rangée comporte le nombre maximal d'erreurs (5 à la figure 1) ou plus. Dans ce cas, le circuit de correction 90 inscrit le rang VPOS de la rangée dans une mémoire 92. La rangée entière sera considérée comme douteuse. Deux mémoires similaires supplémentaires 93 et 94 stockent les positions des rangées douteuses des deux trames précédentes n-1 et n-2.

Le circuit de calcul de syndromes 10' ne calcule, au vol, que les syndromes verticaux VS à partir des données corrigées horizontalement fournies par le circuit de correction 90. Les syndromes verticaux, de la manière précédemment décrite, sont calculés par mises à jour successives dans l'une (ici 14') des zones mémoire 14' à 16' utilisées de manière circulaire.

Le marquage des rangées douteuses non-corrigées par le circuit de correction horizontal 90 fournit directement les positions des erreurs éventuelles dans les colonnes et chaque syndrome vertical permettra de trouver les valeurs des erreurs dans la colonne associée. Ainsi, dans l'exemple de la figure 1, chaque syndrome vertical permettra de trouver au plus 16 valeurs d'erreur. Si le circuit de correction horizontal 90 a marqué plus de 16 rangées non-corrigées, les erreurs ne pourront pas être corrigées.

Le fait de connaître les positions des rangées douteuses simplifie notablement la procédure de correction d'erreur verticale.

Dans un codage Reed-Solomon, les erreurs et les syndromes sont liés par la relation :

$$\lambda(x)S(x) = \Omega(x)$$

où $\lambda(x)$ est un polynôme dit de localisation d'erreur et $\Omega(x)$ un polynôme permettant de trouver les valeurs des erreurs. Le polynôme $\lambda(x)$ est formé par le produit des termes $1 + x\alpha^p$, où $\alpha$ est un élément non nul et non unitaire du corps de Galois, et p la position d'une erreur dans la colonne. Lorsque les valeurs et les positions des erreurs sont inconnues, on doit déterminer les deux polynômes $\lambda$ et $\Omega$ en mettant en oeuvre l'algorithme dit d'Euclide. Ceci représente un nombre de calculs important. Par contre, lorsque les positions sont connues, on connaît directement le polynôme $\lambda$, et le polynôme $\Omega$ est obtenu directement à partir de la relation ci-dessus.

Les valeurs des erreurs sont exprimées par :

$$e_p = \frac{\Omega(\alpha^{-p})}{\alpha^{-p} \cdot \lambda'(\alpha^{-p})} \tag{1}$$

où $\lambda'(x)$ est le polynôme dérivé du polynôme $\lambda$. Le polynôme $x\lambda'(x)$ est constitué par les seuls termes de puissances impaires du polynôme $\lambda(x)$.

Lorsque les syndromes verticaux d'une trame n sont calculés dans la zone 14', un circuit 96 de calcul des polynômes $\Omega$ et $\lambda$ agit sur la zone 15' associée à la trame n-1 tandis que le circuit de calcul d'erreurs 17' agit sur la zone 16' associée à la trame n-2.

Chacune des zones 14' à 16' comporte une région supplémentaire destinée à recevoir les coefficients du polynôme $\lambda$ associé à une trame. Ce polynôme $\lambda$ est unique pour toutes les colonnes de la trame, puisque les positions des erreurs éventuelles sont les mêmes dans chaque colonne. Dans la zone mémoire 14', le polynôme $\lambda$ de la tranche n n'a pas encore été calculé. Dans la zone 15', les coefficients du polynôme $\lambda$ associés à la tranche n-1 sont en cours de calcul. Finalement, dans la zone 16', le polynôme $\lambda$ associé à la tranche n-2 est exploité par le circuit de calcul d'erreurs 17' pour calculer les valeurs des erreurs.

Dans la zone mémoire 15', le circuit de calcul 96 remplace chaque syndrome vertical par le polynôme $\Omega$ correspondant. Pour ce faire, le circuit 96 lit chaque position d'erreur p dans la mémoire 93 et calcule le polynôme $\Omega$ associé à chaque colonne par mises à jour successives selon la relation :

$$\Omega(x) = (1 + x\alpha P)\Omega(x),$$

où p prend successivement toutes les positions d'erreur et $\Omega(x)$ est initialement égal au syndrome S(x) associé à la colonne. De même, le polynôme $\lambda$ est mis à jour selon la relation :

$$\lambda(x) = (1+x\alpha P)\lambda(x),$$

$\lambda(x)$ étant initialement égal à 1 (polynôme unitaire).

De manière plus concrète, chaque coefficient $\Omega_j$ est modifié selon la relation :

$$\Omega_j = \Omega_j + \alpha^p \, \Omega_{j-1},$$

où, dans l'exemple de la figure 1, j varie de 15 à 0 pour chaque position d'erreur p. Les coefficients du polynôme $\lambda$ sont mis à jour selon la même relation.

Le circuit de calcul d'erreurs 17' exploite les polynômes $\Omega$ associés respectivement aux colonnes et le polynôme $\lambda$ commun stockés dans la zone 16' pour calculer les valeurs d'erreur successives $e_p$ des rangées douteuses de la trame n-2. De manière concrète, le numérateur N du rapport de la relation (1) ci-dessus est stocké dans un registre qui est mis à jour selon la relation :

$$N_p = \alpha^{-p} \, N_p + \Omega_j$$

où j varie de 15 à 0 pour chaque position d'erreur p trouvée dans la mémoire 94. En faisant varier p dans l'ordre de stockage des positions dans la mémoire 94, les valeurs d'erreur $e_p$ seront obtenues dans l'ordre de transmission des rangées.

Le dénominateur de la relation (1) ci-dessus est mis à jour de manière similaire à partir du polynôme $\lambda$, sauf que l'indice j varie de 15 à 1 par valeurs impaires. Ensuite, ce dénominateur est inversé et multiplié par le numérateur de manière classique.

Le circuit de correction 21' reçoit, de la zone mémoire 94, les positions p des rangées douteuses. Lorsqu'une position p correspond à la rangée en cours de transmission, les valeurs d'erreur $e_p$ fournies par le circuit de calcul 17' sont ajoutées respectivement aux données transmises par le circuit de correction 21'.

Selon une variante du mode de réalisation de la figure 7, si l'on dispose de suffisamment de puissance de calcul, la troisième zone mémoire 16' et le circuit de correction 21' peuvent être omis. Alors, le circuit de calcul d'erreurs 17' agit sur la zone mémoire 15' après que le circuit 96 a écrit dans la zone 15' les polynômes $\Omega$ et $\lambda$. Toutes les données d'une rangée douteuse sont supposées nulles, même celles qui sont correctes sans ambiguïté, et les syndromes verticaux sont calculés pour tenir compte de cela. Il en résulte que les valeurs d'erreur trouvées par le circuit 17' sont directement les données correctes des rangées douteuses. Le circuit 96 doit avoir calculé tous les polynômes $\Omega$ et le circuit 17' toutes les valeurs d'erreur d'une première rangée douteuse avant l'arrivée de la première rangée de parité verticale de la trame n. En effet, pendant la réception de chaque rangée de parité verticale, que l'on n'écrit pas dans la zone M1 de la mémoire 12, le circuit de correction 17' écrit dans la zone M2, à la place d'une rangée douteuse de la trame n-1, les valeurs d'erreur de la rangée douteuse. On corrige ainsi les rangées douteuses dans la mémoire 12 sans qu'il soit nécessaire d'accroître la vitesse d'accès à cette mémoire 12.

Bien entendu, le mode de réalisation de la figure 7 et sa variante peuvent, comme le mode de réalisation de la figure 3, être utilisés avec un processeur 32 associé à une mémoire 34 dans laquelle sont envoyées les trames en attente de correction.

## Revendications

**1.** Procédé de correction d'erreurs dans une trame de données comportant des données de parité horizontale (HP) permettant de corriger des erreurs dans les rangées de la trame à partir de syndromes horizontaux (HS) calculés sur les rangées, et des données de parité verticale (VP) permettant de corriger des erreurs dans les colonnes de la trame à partir de syndromes verticaux (VS) calculés sur les colonnes, **caractérisé en ce qu'**il comprend les étapes suivantes :

- calculer au vol (10) les syndromes horizontaux et verticaux d'une trame courante sur les données de la trame courante en cours de réception dans une mémoire lente (12, 34) et stocker ces syndromes dans une zone mémoire rapide (14, 15) ; et

- tandis que les données de la trame suivante sont reçues dans la mémoire lente, trouver (17) les valeurs et positions des erreurs de la trame courante à partir des syndromes stockés dans la zone mémoire rapide.

2. Procédé de correction d'erreurs dans une trame de données comportant des données de parité horizontale (HP) permettant de corriger des erreurs dans les rangées de la trame à partir de syndromes horizontaux (HS) calculés sur les rangées, et des données de parité verticale (VP) permettant de corriger des erreurs dans les colonnes de la trame à partir de syndromes verticaux (VS) calculés sur les colonnes, **caractérisé en ce qu'**il comprend les étapes suivantes :

- tandis que les données d'une trame courante sont reçues par rangées, tenter de corriger au vol les rangées de la trame courante à l'aide des données de parité horizontale et marquer les positions de rangées douteuses ;
- calculer au vol (10') les syndromes verticaux (VS) de la trame courante sur les rangées corrigées et douteuses en cours de stockage dans une mémoire lente (12, 34) et stocker les syndromes verticaux dans une zone mémoire rapide (14', 15', 16') ; et
- tandis que les données de la trame suivante sont reçues, trouver (17') les valeurs des erreurs de la trame courante à partir des syndromes verticaux stockés dans la zone mémoire rapide, les positions de ces erreurs étant fournies par le marquage des rangées douteuses.

3. Procédé de correction d'erreurs selon la revendication 1 ou 2, **caractérisé en ce qu'**il comprend l'étape consistant à corriger au vol (21) les données extraites de la mémoire lente (12) par les valeurs et positions trouvées.

4. Procédé de correction d'erreurs selon la revendication 1 ou 2, **caractérisé en ce que** la mémoire lente (34) est gérée par un circuit d'exploitation (32) et les valeurs et positions des erreurs de chaque trame sont fournies au circuit d'exploitation parmi les données de la trame suivante, le circuit d'exploitation étant prévu pour stocker chaque trame et la corriger lors de la réception des valeurs et positions des erreurs correspondantes.

5. Procédé de correction d'erreurs selon la revendication 4, **caractérisé en ce que** chaque trame est stockée sans ses données de parité (HP, VP), les valeurs et positions des erreurs de la trame étant fournies au circuit d'exploitation (32) pendant la réception des données de parité de la trame suivante.

6. Procédé de correction d'erreurs selon la revendication 3 ou 4, dans lequel les données de parité constituent avec les données restantes des codes Reed-Solomon, chaque coefficient d'un syndrome calculé sur une rangée ou une colonne de la trame étant la valeur prise par un polynôme, dont les coefficients sont constitués par les données de la rangée ou colonne, pour un élément d'un corps de Galois élevé à une puissance correspondante, **caractérisé en ce que** les données de parité verticale sont entrelacées dans les colonnes, le calcul de syndromes comprenant les étapes suivantes :

- initialiser un premier registre auxiliaire (58) à un élément prédéterminé ($\alpha$) du corps de Galois, élevé à une puissance (207) correspondant à la première donnée de chaque colonne ;
- initialiser un deuxième registre auxiliaire (60) audit élément ($\alpha$) du corps de Galois, élevé à une puissance (15) correspondant à la première donnée de parité verticale de la colonne ;
- initialiser à 1 un registre de variable (52) ;
- mettre à jour le premier registre auxiliaire (58) par le produit de son contenu et de l'inverse dudit élément du corps de Galois à chaque arrivée d'une nouvelle donnée ($a_r$) de la colonne, sauf lors de l'arrivée d'une donnée de parité verticale ;
- mettre à jour le deuxième registre auxiliaire (60) par le produit de son contenu et de l'inverse dudit élément du corps de Galois à chaque arrivée d'une nouvelle donnée de parité verticale de la colonne ;
- mettre à jour le registre de variable (52), pour chaque coefficient de syndrome, par le produit de son contenu et du contenu du deuxième ou premier registre auxiliaire, selon que la donnée couramment reçue de la colonne est une donnée de parité verticale ou non ; et
- mettre à jour, dans la zone mémoire rapide (14), chaque coefficient de syndrome vertical par la somme (54) du coefficient de syndrome et du produit du contenu du registre de variable par la donnée couramment reçue ($a_r$).

7. Procédé de correction d'erreurs selon la revendication 4, dans lequel la trame de données comporte des signatures de vérification d'erreurs (CRC) dont chacune correspond au reste de la division par un polynôme générateur (g) d'un polynôme dont les coefficients sont les bits d'une série de données de la trame, **caractérisé en ce qu'**il comprend les étapes suivantes :

- initialiser un premier registre (76), pour chaque erreur trouvée, aux coefficients du polynôme générateur (g) et le mettre à jour par le carré (78) de son contenu ;
- initialiser un registre à décalage (72) à la position de l'erreur dans la série et le cadencer en synchronisme avec les mises à jour du premier registre (76) ; et
- initialiser un registre de signature (70) à la valeur de l'erreur et le mettre à jour par le produit de son contenu et du contenu du premier registre seulement lorsque le bit de poids le plus faible (LSB) du registre à décalage (72) est à 1, d'où il résulte que le registre de signature contient l'influence de l'erreur sur la signature lorsque le registre à décalage a été parcouru.

8.  Procédé de correction d'erreurs selon la revendication 1, **caractérisé en ce qu'**il comprend l'étape consistant, tandis que les données de la trame suivante sont reçues, à remplacer, dans la zone mémoire rapide, les coefficients de chaque syndrome par les valeurs et positions des erreurs calculées à partir du syndrome.

9.  Procédé de correction d'erreurs selon la revendication 2, **caractérisé en ce qu'**il comprend les étapes suivantes :

- tandis que les données de la trame suivante sont reçues, remplacer, dans la zone mémoire rapide, les coefficients de chaque syndrome vertical par les coefficients d'un polynôme de détermination d'erreur ($\Omega$) calculé à partir des coefficients du syndrome vertical et des positions des rangées douteuses marquées ;
- stocker les coefficients d'un polynôme de localisation d'erreur ($\lambda$) calculé à partir des positions des rangées douteuses marquées ; et
- calculer les valeurs des erreurs à partir des polynômes de détermination d'erreur et du polynôme de localisation d'erreur.

10. Procédé de correction d'erreurs selon la revendication 9, **caractérisé en ce qu'**il comprend les étapes suivantes :

- calculer les syndromes verticaux de la trame courante en annulant les données de chaque rangée douteuse ; et
- pendant la réception d'une rangée de données de parité verticale de la trame suivante, écrire les valeurs d'erreur calculées pour une rangée douteuse dans la mémoire lente à la place de cette rangée douteuse.

**Patentansprüche**

1.  Verfahren zur Fehlerkorrektur in einem Raster von Daten, welcher horizontale Paritätsdaten (HP) umfasst, die die Korrektur von Fehlern in den Zeilen des Rasters auf der Grundlage von an den Zeilen berechneten horizontalen Syndromen (HS) gestatten, sowie vertikale Paritätsdaten (VP), welche die Korrektur von Fehlern in den Spalten des Rasters auf der Grundlage von an den Spalten berechneten vertikalen Syndromen (VS) gestatten, **dadurch gekennzeichnet dass** das Verfahren die folgenden Schritte bzw. Stufen umfasst:

- fliegendes Berechnen (10) der Horizontal- und Vertikalsyndrome eines laufenden Bildrasters an den Daten des laufenden Rasters im Verlauf des Empfangs in einem langsamen Speicher (12,34), und Speichern dieser Syndrome in einem schnellen Speicherbereich (14,15); sowie
- während des Empfangs der Daten des folgenden Rasterbilds in dem langsamen Speicher Aufsuchen (17) der Betragswerte und der Stellen bzw. Positionen der Fehler in dem laufenden Bildraster auf der Grundlage der in dem schnellen Speicherbereich gespeicherten Syndrome.

2.  Verfahren zur Korrektur von Fehlern in einem Datenraster mit horizontalen Paritätsdaten (HP), welche eine Korrektur von Fehlern in den Zeilen des Rasters auf der Grundlage von an den Zeilen berechneten horizontalen Syndromen (HS) gestatten, sowie mit vertikalen Paritätsdaten (VP), welche die Korrektur von Fehlern in den Spalten des Bildrasters auf der Grundlage von an den Spalten berechneten vertikalen Syndromen (VS) gestatten, **dadurch gekennzeichnet dass** das Verfahren die folgenden Schritte bzw. Stufen umfasst:

- während die Daten eines laufenden Bildrasters zeilenweise empfangen werden Versuch zur fliegenden Korrektur der Zeilen des laufenden Rasters mit Hilfe von horizontalen Paritätsdaten, und Markieren der Stellen von zweifelhaften Zeilen;
- fliegendes Berechnen (10') der Vertikalsyndrome (VS) des laufenden Rasters an den korrigierten und zweifelhaften Zeilen im Verlauf der Speicherung in einem langsamen Speicher (12,34) und Speichern der Vertikalsyndrome in einer schnellen Speicherzone (14', 15', 16'), sowie
- während dem Empfang der Daten des folgenden Bildrasters Aufsuchen (17') der Beträge der Fehler des laufenden Bildrasters auf der Grundlage der in der schnellen Speicherzone gespeicherten Vertikalsyndrome, wobei die Stellen bzw. Lagen dieser Fehler durch die Markierung der zweifelhaften Zeilen geliefert werden.

3. Verfahren zur Fehlerkorrektur nach Anspruch 1 oder 2, **dadurch gekennzeichnet, dass** das Verfahren den Schritt bzw. die Stufe umfasst, welche in der fliegenden Korrektur (21) der aus dem langsamen Speicher (12) mit den aufgefundenen Beträgen und Stellen extrahierten Daten besteht.

4. Verfahren zur Fehlerkorrektur nach Anspruch 1 oder 2, **dadurch gekennzeichnet, dass** der langsame Speicher (34) von einer Ver- bzw. Auswertungsschaltung (32) verwaltet wird und dass die Beträge und Stellen (Lagen) der Fehler jedes Rasters der Auswertschaltung unter den Daten des folgenden Bildrasters zugeführt werden, und dass die Auswertschaltung vorgesehen ist, um jeweils jeden Bildraster zu speichern und ihn bei Empfang der Betragswerte und der Stellen bzw. Lagen der betreffenden Fehler zu korrigieren.

5. Verfahren zur Fehlerkorrektur nach Anspruch 4, **dadurch gekennzeichnet, dass** jeder Bildraster jeweils ohne seine Paritätsdaten (HP,VP) gespeichert wird und dass die Beträge und Stellen (Lagen) der Fehler des Rasters der Auswertschaltung (32) während des Empfangs der Paritätsdaten des folgenden Bildrasters zugeführt werden.

6. Verfahren zur Fehlerkorrektur nach Anspruch 3 oder 4, bei welchem die Paritätsdaten mit den übrigen Daten Reed-Solomon-Codes bilden, wobei jeweils jeder Koeffizient eines an einer Zeile oder einer Spalte des Bildrasters berechneten Syndroms der von einem Polynom angenommene Wert ist, dessen Koeffizienten von den Daten der Zeile oder Spalte gebildet werden, für ein zu einer entsprechenden Potenz erhobenes Element eines Galois-Körpers, **dadurch gekennzeichnet, dass** die vertikalen Paritätsdaten in den Spalten verschränkt bzw. verschachtelt sind, und dass die Syndrom-Berechnung die folgenden Stufen bzw. Schritte umfasst:

- Initialisieren eines ersten Hilfsregisters (58) auf ein vorgegebenes Element ($\alpha$) des Galoiskörpers, das zu einer dem ersten Datum jeder Spalte entsprechenden Potenz (207) erhoben ist;
- Initialisieren eines zweiten Hilfsregisters (60) auf das genannte Element ($\alpha$) des Galoiskörpers, das in eine dem ersten vertikalen Paritäts-Datum der Spalte entsprechende Potenz (15) erhoben ist;
- Initialisieren eines variablen Registers (52) auf 1;
- Aktualisieren des ersten Hilfsregisters (58) mit dem Produkt aus seinem Inhalt und dem Inversen des genannten Galoiskörper-Elements, jeweils beim Eintreffen eines neuen Datums ($a_r$) der Spalte, außer beim Eintreffen eines Vertikalparitätsdatums;
- Aktualisieren des zweiten Hilfsregisters (60) mit dem Produkt aus seinem Inhalt und dem Inversen des genannten Galoiskörper- Elements, jeweils bei jedem Eintreffen eines neuen Vertikalparitäts-Datums der Spalte;
- Aktualisieren des variablen Registers (52) für jeden Syndromkoeffizienten mit dem Produkt aus seinem Inhalt und dem Inhalt des ersten oder des zweiten Hilfsregisters, je nachdem ob das jeweilige laufend empfangene Datum der Spalte ein vertikales Paritätsdatum ist oder nicht; sowie
- Aktualisieren, in der schnellen Speicherzone (14), jeweils jedes Vertikal-Syndrom-Koeffizienten mit der Summe (54) aus dem Syndromkoeffizienten und dem Produkt aus dem Inhalt des variablen Registers mit dem laufend empfangenen Datum ($a_r$).

7. Verfahren zur Fehlerkorrektur nach Anspruch 4, bei welchem der Datenraster Fehlerverifikations- bzw.-prüf-Signaturen (CRC) umfasst, deren jede jeweils dem Rest der Division eines Polynoms, dessen Koeffizienten die bits von Daten des Rasters sind, durch ein Generatorpolynom (g) entspricht, **dadurch gekennzeichnet, dass** das Verfahren die folgenden Schritte bzw. Stufen umfasst:

- Initialisieren eines ersten Registers (76), jeweils für jeden gefundenen Fehler, auf die Koeffizienten des Generatorpolynoms (g), und seine Aktualisierung mit dem Quadrat (78) seines Inhalts;
- Initialisieren eines Schieberegisters (72) auf die Stellung bzw. Lage des Fehlers in der Serie, und seine Taktsteuerung in Synchronismus mit den Aktualisierungen des ersten Registers (76); sowie
- Initialisieren eines Signaturregisters (70) auf den Betrag des Fehlers und seine Aktualisierung mit dem Produkt aus seinem Inhalt und dem Inhalt des ersten Registers nur wenn das niedrigstwertige Bit (LSB) des Schieberegisters (72) 1 beträgt, mit dem Ergebnis, dass das Signaturregister den Einfluß des Fehlers auf die Signatur enthält, wenn das Schieberegister voll durchlaufen ist.

8. Verfahren zur Fehlerkorrektur nach Anspruch 1, **dadurch gekennzeichnet, dass** das Verfahren den Schritt bzw. die Stufe umfasst, dass während dem Empfang der Daten des folgenden Bildrasters in der schnellen Speicherzone die Koeffizienten jedes Syndroms jeweils durch die Betragswerte und die Stellungen bzw. Lagen der auf der Grund-

**EP 0 821 493 B1**

lage des Syndroms berechneten Fehler ersetzt werden.

9. Verfahren zur Fehlerkorrektur nach Anspruch 2, **dadurch gekennzeichnet, dass** es die folgenden Schritte bzw. Stufen umfasst:

   - während dem Empfang der Daten des folgenden Bildrasters Ersetzen, in der schnellen Speicherzone, der Koeffizienten jeweils jedes Vertikalsyndroms durch die Koeffizienten eines Fehlerbestimmungs-Polynoms (Ω), das auf der Grundlage der Koeffizienten des Vertikalsyndroms und der Stellen bzw. Lagen der markierten zweifelhaften Zeilen berechnet wird;
   - Speichern der Koeffizienten eines auf der Grundlage der Lage bzw. Stellung der markierten zweifelhaften Zeilen berechneten Fehler-Lokalisierungs-Polynoms (λ); sowie
   - Berechnen der Betragswerte der Fehler auf der Grundlage der Fehlerbestimmungs-Polynome und des Fehlerlokalisierungs-Polynoms.

10. Verfahren zur Fehlerkorrektur nach Anspruch 9, **dadurch gekennzeichnet, dass** es die folgenden Schritte bzw. Stufen umfasst:

   - Berechnen der Vertikalsyndrome des laufenden Bildrasters unter Annulierung der Daten jeweils jeder zweifelhaften Zeile; sowie
   - während dem Empfang einer Zeile von vertikalen Paritätsdaten des folgenden Bildrasters Einschreiben der für eine zweifelhafte Zeile berechneten Fehlerbetragswerte in dem langsamen Speicher anstelle der zweifelhaften Zeile.

**Claims**

1. A method for correcting errors in a data frame including horizontal parity data (HP) enabling correction of errors in the rows of the frame based on horizontal syndromes (HS) calculated on the rows, and vertical parity data (VP) enabling correction of errors in the columns of the frame based on vertical syndromes (VS) calculated on the columns, **characterized in that** it includes the steps of:

   - calculating on the fly (10) the horizontal and vertical syndromes of a current frame based on the data of the current frame being received in a slow memory (12, 34) and storing these syndromes in a fast memory area (14, 15); and
   - as the data of the next frame are being received in the slow memory, finding (17) the values and positions of the errors of the current frame based on the syndromes stored in the fast memory area.

2. A method for correcting errors in a data frame including horizontal parity data (HP) enabling correction of errors in the rows of the frame based on horizontal syndromes (HS) calculated on the rows, and vertical parity. data (VP) enabling correction of errors in the columns of the frame based on vertical syndromes (VS) calculated on the columns, **characterized in that** it includes the steps of:

   - as the data of a current frame are being received by rows, attempting to correct on the fly the rows of the current frame by means of the horizontal parity data and marking the positions of dubious rows;
   - calculating on the fly (10') the vertical syndromes (VS) of the current frame based on the corrected and dubious rows being stored in a slow memory (12, 34) and storing the vertical syndromes in a fast memory area (14', 15', 16'); and
   - as the data of the next frame are being received, finding (17') the values of the errors of the current frame based on the vertical syndromes stored in the fast memory area, the positions of these errors being provided by the marking of the dubious rows.

3. The error correction method according to claim 1 or 2, **characterized in that** it includes the step of correcting, on the fly (21), the data extracted from the slow memory (12) with the found values and positions.

4. The error correction method according to claim 1 or 2, **characterized in that** the slow memory (34) is managed by an exploiting circuit (32) and the values and positions of the errors of each frame are supplied to the exploiting circuit among the data of the next frame, the exploiting circuit being adapted to store each frame and correct it upon reception of the values and positions of the corresponding errors.

**14**

5. The error correction method according to claim 4, **characterized in that** each frame is stored without its parity data (HP, VP), the values and positions of the frame errors being supplied to the exploiting circuit (32) during the reception of the parity data of the next frame.

6. The error correction method according to claim 3 or 4, wherein the parity data constitute with the remaining data Reed-Solomon codes, each coefficient of a syndrome calculated on a row or a column of the frame being the value taken by a polynomial, having coefficients constituted by the data of the row or column, for an element of a Galois field raised to a corresponding power, **characterized in that** the vertical parity data are interlaced in the columns, the syndrome calculation including the steps of:

   - setting a first auxiliary register (58) to a predetermined element ($\alpha$) of the Galois field, raised to a power (207) corresponding to the first datum of each column;
   - setting a second auxiliary register (60) to said element ($\alpha$) of the Galois field, raised to a power (15) corresponding to the first vertical parity datum of the column;
   - setting to 1 a variable register (52);
   - updating the first auxiliary register (58) with the product of its content by the inverse of said element of the Galois field upon each arrival of a new datum ($a_r$) of the column, except upon arrival of a vertical parity datum;
   - updating the second auxiliary register (60) with the product of its content by the inverse of said element of the Galois field upon each arrival of a new vertical parity datum of the column;
   - updating the variable register (52), for each syndrome coefficient, with the product of its content by the content of the second or first auxiliary register, according to whether the column datum currently received is or is not a vertical parity datum; and
   - updating, in the fast memory area (14), each vertical syndrome coefficient with the sum (54) of the syndrome coefficient and of the product of the content of the variable register by the currently received datum ($a_r$).

7. The error correction method according to claim 4, wherein the data frame includes error checking signatures (CRC), each of which corresponds to the remainder of the division by a generator polynomial (g) of a polynomial whose coefficients are the bits of a series of data of the frame, **characterized in that** it includes the steps of:

   - setting a first register (76), for each error found, to the coefficients of the generator polynomial (g) and updating it with the square (78) of its content;
   - setting a shift register (72) with the position of the error in said series and clocking it synchronously with the updates of the first register (76); and
   - setting a signature register (70) to the value of the error and updating it with the product of its content by the content of the first register only when the least significant bit (LSB) of the shift register (72) is at 1, whereby the signature register contains the influence of the error upon the signature when the shift register has been fully shifted.

8. The error correction method according to claim 1, **characterized in that** it includes the step of, as the data of the next frame are being received, replacing, in a fast memory area, the coefficients of each syndrome with the values and positions of the errors calculated with the syndrome.

9. The error correction method according to claim 2, **characterized in that** it includes the steps of:

   - as the data of the next frame are being received, replacing, in the fast memory area, the coefficients of each vertical syndrome with the coefficients of an error determination polynomial ($\Omega$) calculated with the coefficients of the vertical syndrome and the positions of the marked dubious rows;
   - storing the coefficients of an error locator polynomial ($\lambda$) calculated with the positions of the marked dubious rows; and
   - calculating the error values with the error determination polynomial and the error locator polynomial.

10. The error correction method according to claim 9, **characterized in that** it includes the steps of:

   - calculating the vertical syndromes of the current frame, the data of each dubious row being canceled; and
   - during the reception of a row of vertical parity data of the next frame, writing the calculated error values for a dubious row into the slow memory in place of this dubious row.

Fig 1

Fig 2A

Fig 2B

Fig 3

Fig 4

Fig 5

Fig 6

Fig 7